# EUROPEAN PATENT SPECIFICATION

(11) **EP 0 927 888 B1**
(45) Date of publication and mention of the grant of the patent: **29.09.2004**
(21) Application number: 98403232.6
(22) Date of filing: 21.12.1998
(51) Int. Cl.: G01R 31/28, G11B 7/13

(54) **Automatically adapting forward or reversed biased photodiode detection circuit**
Photodiodendetektorschaltung zur automatischen Anpassung an Vorwärtsvorspannung oder umgekehrter Vorspannung
Circuit de détection de photodiode pour la configuration automatique en polarisation directe ou polarisation inversée

(30) Priority: 29.12.1997 EP 97403172
(43) Date of publication of application: 07.07.1999
(73) Proprietor: Deutsche Thomson Brandt, 78048 Villingen (DE)
(72) Inventor: Buechler, Christian, 92648 Boulogne (FR); Lehr, Steffen, 92648 Boulogne (FR); Zucker, Friedhelm, 92648 Boulogne (FR)
(74) Representative: Zhang, Jianguo

(56) References cited:
- EP-A- 0 305 148
- EP-A- 0 782 251
- US-A- 4 713 819
- US-A- 5 355 082

## Description

The present invention relates to a method and a circuit which allow to automatically obtain a forward or a reversed biased photodiode detection device. The invention may for example be used in optical disk players and/or recorders.

In many applications where light is used e.g. as a tool to work on material or as a means to scan information stored on an information medium, thus applications in which a light source is involved, it appears necessary to keep a light intensity constant at a predetermined level at some stage of a process. Typically the light intensity is measured using a photodetector, a result of this measurement is compared with a reference value and a power fed to the light source accordingly regulated.

For some applications it is common to use photodiodes to measure the light intensity, these being a kind of photodetector which in practice may be used in a photodiode circuit of a forward biased or a reversed biased type. The use of either a forward biased or a reversed biased photodiode circuit is typically subjected to an availability of either one type of photodiode circuit on the market. For reasons of flexibility to market conditions a light intensity measuring circuit using photodiodes should be able to use either one of the forward biased or reversed biased photodiode circuit.

EP 0 305 148 discloses a system and a method for unambiguously determining the orientation of a semiconductor component in a circuit. A predetermined biasing current is drawn from a signal node of the circuit, which is sufficient to forward bias protection and/or parasitic diodes that exist between a ground pin and a signal pin of the semiconductor component.

From US 4,713,819 a semiconductor laser driver including a discrimination circuit for determining the status of a photodiode is known. A forward bias source or a reverse bias source is coupled to the photodiode through a switch. When a power source is turned on, the switch is switched to connect the forward bias source to the photodiode. A forward bias current is applied to the photodiode. At this time, a driver circuit has not yet been supplying a drive current to the semiconductor laser. With a forward bias current applied, a forward voltage drop is generated across the photodiode. A discrimination circuit compares the forward voltage drop to a reference voltage range. When the forward voltage drop is outside the range, it is determined that the photodiode is abnormal, and the driver circuit is controlled such that no drive current is supplied to the semiconductor laser. When the forward voltage drop is in the reference voltage range, the operation of the driver circuit is started, and the switch is switched to connect the reverse bias source to the photodiode.

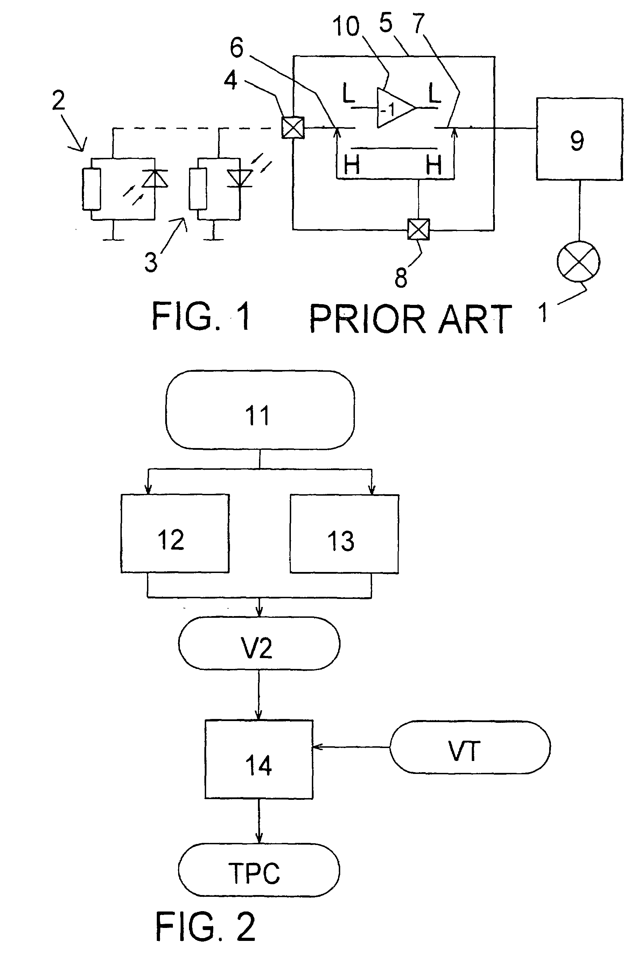

A configuration known from prior art and shown in Fig. 1 is used to regulate a light intensity emitted by a light source 1. Either one of a reversed biased photodiode circuit 2 or a forward biased photodiode circuit 3 may be used to determine a light intensity emitted by the light source 1. Either one of photodiode circuits 2 or 3 is connected to an input 4 of a detection device 5 (shown by a dotted connection line). The detection device comprises switches 6 and 7 which may simultaneously be switched when an appropriate signal is applied to a switching control input 8. In case the forward biased photodiode circuit 3 is connected to the input 4 the switches 5 and 6 are switched to the state H and a photovoltage at input 4 is directly transmitted to power regulating means 9. The power regulating means 9 allow to compare the photovoltage to a reference photovoltage and accordingly regulate a power amplitude fed to the light source 1 in order to maintain a value of the photovoltage to a value of the referenced photovoltage. In an alternative case where the reversed biased photodiode circuit 2 is connected to the input 4 the switches 6 and 7 are switched to the position L. A photovoltage at the input 4 is inverted by the inverter 10 before being transmitted to the power regulating means 9.

A drawback of the known configuration in Fig. 1 is that when either photodiode circuit 2 or 3 is connected to the input 4 the appropriate signal has to be applied to the switching control input 8 by means of an external intervention on the switching control input 8 e.g. by soldering (or de-soldering) the switching control input 8 to (from) ground. The known configuration is typically realized as part of an integrated circuit and the switching control input 8 is one of many pins of this integrated circuit. Soldering the single switching control input pin of the integrated circuit to ground is a delicate manufacturing process which is subject to errors.

It is an object of the invention to find a solution for a detection method or circuit in which either one of a forward biased or a reversed biased photodiode circuit may be used but in which the need for an external intervention on the detection circuit to adapt the detection circuit to the type of photodiode circuit connected to it is eliminated.

A solution to the above described problem is according to the present invention found in a method for automatically identifying a first or a second type of photodiode circuit which each have a first and a second output and which comprises the steps of:
- connecting the first output to ground,
- connecting to the second output a current source of a predetermined current value,
- comparing a voltage at the second output with a predetermined reference voltage,
- emitting a signal indicating a result of the comparing which allows an identification of either the first or the second type of photodiode circuit.

The steps of the method according to the invention may be performed automatically and identify a first or a second type of photodiode circuit, e.g. a forward biased or a reversed biased photodiode type circuit.

Another solution to the above described problem is according to the invention found in a method for automatically obtaining a forward or a reversed biased photodiode device which delivers between a first and a second electrode a photovoltage of a predetermined polarity, depending on either one of a first or a second type of photodiode circuit which each have a first and a second output. The method comprises the steps of:
- connecting the first output to ground,
- connecting to the second output a current source of a predetermined current value,
- comparing a voltage at the second output with a predetermined reference voltage,
- emitting a signal indicating a result of the comparing which allows an identification of at least the second type of photodiode circuit,
- storing the signal,
- disconnecting the first output from ground and the second output from the current source,
- connecting the first and the second output to the first and second electrode respectively,
- maintaining the second output at a constant reverse biasing voltage if said stored signal identifies the second type of photodiode circuit by comparing a biasing voltage value at the second output with a reference biasing voltage value and accordingly to a result of this comparison applying a variable current to the first output.

Yet another solution to the above described problem is according to the present invention found in a method for controlling an intensity of a light source in which following steps are comprised:
- connecting either one of a first or a second type of photodiode circuit to a detection circuit,
- adapting said detection circuit for the first or the second type of the photodiode circuit connected to it,
- receiving on at least a photodiode of the first or the second photodiode circuit light emitted by said light source,
- obtaining at an output of the detection circuit a photovoltage of a predetermined polarity,
- regulating an intensity of the light source such to maintain the photovoltage at a reference photovoltage value.

The method further comprises the steps of:
- disconnecting the detection circuit from the first or the second type of photodiode circuit,
- connecting to the first or the second type of photodiode circuit a test circuit,
- determining at least whether the second type of photodiode circuit is connected to the test circuit.
- storing a positive value if the determining reveals the second type of photodiode circuit,
- disconnecting the test circuit,
- performing the adapting for said second type of photodiode circuit if the stored result is positive, or else for the first type of photodiode circuit.

Yet another solution to the above described problem is according to the present invention found in an automatically adapting forward or reversed biased photodiode detection circuit comprising a first and a second input for connecting a photodiode circuit, the first input being connected to ground over a first switch, the second input being connected over a second switch to a current source and over a third switch to voltage evaluating means. The detection circuit further comprises first switching for simultaneously opening or closing the first, second and third switches, regulating means having an input connected over a fourth switch to the second input and an output connected over a fifth switch to the first input to regulate a biasing voltage at the second input to a predetermined reverse biasing voltage. Furthermore, it comprises second switching means for simultaneously opening or closing the fourth and fifth switches, these being connected to an output of said voltage evaluating means and to the first switching means.

The detection circuit according to the invention is a simple way of realizing the method for automatically obtaining a forward or a reversed biased photodiode device.

In a preferred embodiment of the detection circuit the voltage evaluating means comprise a voltage source which generates a predetermined reference voltage, a voltage comparator one input of which is connected to the voltage source, another input of which is connected to the third switch, a memory device to store a result of a comparison delivered at an output of the voltage comparator:

In another preferred embodiment of the detection circuit the regulating means comprise a further voltage source which generates the predetermined reversed biasing voltage, an amplifier an input of which is connected to the further voltage source, another input of which is connected to the fourth switch, an output of which is connected to the fifth switch.

Yet another solution to the above described problem is according to the invention found in a light intensity monitoring and controlling circuit which comprises an automatically adapting forward and reversed biased photodiode detection circuit as described above, further voltage evaluating means to determine a photovoltage value of a voltage between the first and second input, the further evaluating means having a first and a second evaluating input connected to the first and the second input through a sixth and a seventh switch respectively, the photovoltage value being emitted at an evaluating output, third switching means which allow to simultaneously open or close the sixth and the seventh switch and an input of which is connected to the second switching means, power regulating means which allow to regulate an intensity of a light source as a function of the photovoltage value, the power regulating means being connected to the evaluating output.

In a preferred embodiment of the light intensity monitoring and controlling circuit the power regulating means comprise a reference voltage source which generates a predetermined reference voltage, photovoltage comparing means to compare said predetermined reference photovoltage with the photovoltage, a result of the photovoltage comparing being used to regulate the intensity.

The light intensity monitoring and controlling circuit allows a simple realization of the method for controlling an intensity of a light source according to the invention.

In the following a detailed description of ways to carry out the invention will be given using examples and referring to Figs 1 to 11 wherein:
FIG.1 shows a configuration used to regulate a light intensity as known from prior art,
FIG.2 contains a flowchart which illustrates a method for automatically identifying a first or a second type of photodiode circuit,
FIG.3 contains a flowchart illustrating a method for automatically obtaining a forward or a reversed biased photodiode circuit device,
FIG.4 contains a flowchart illustrating a method for controlling an intensity of a light source,
FIG.5 contains a schematical illustration of an automatically adapting forward or reversed biased photodiode detection circuit,
FIG.6 and FIG.7 contain schematical illustrations of a first and a second photodiode circuit,
FIG.8 contains a schematical representation of voltage evaluating means,
FIG.9 contains a schematical representation of regulating means,
FIG.10 contains a schematical representation of a light intensity monitoring and controlling circuit,
FIG.11 contains a schematical representation of power regulating means.

Throughout the description same references will be used to designate same objets.

A flowchart in FIG.2 shows that departing from a first or a second type of photodiode circuit in box 11 which each have a first and a second output, the first output is connected in a step 12 to ground and the second output is connected in a step 13 to a current source of a predetermined current value. As a result, a voltage V2 is obtained at the second output. The voltage V2 is compared in a step 14 with a predetermined reference voltage VT. Following step 14 a signal TPC which indicates a result of the comparing and allows an identification of either the first or the second type of photodiode circuit in box 11 is emitted. Hence the photodiode circuit from box 11 is tested and identified.

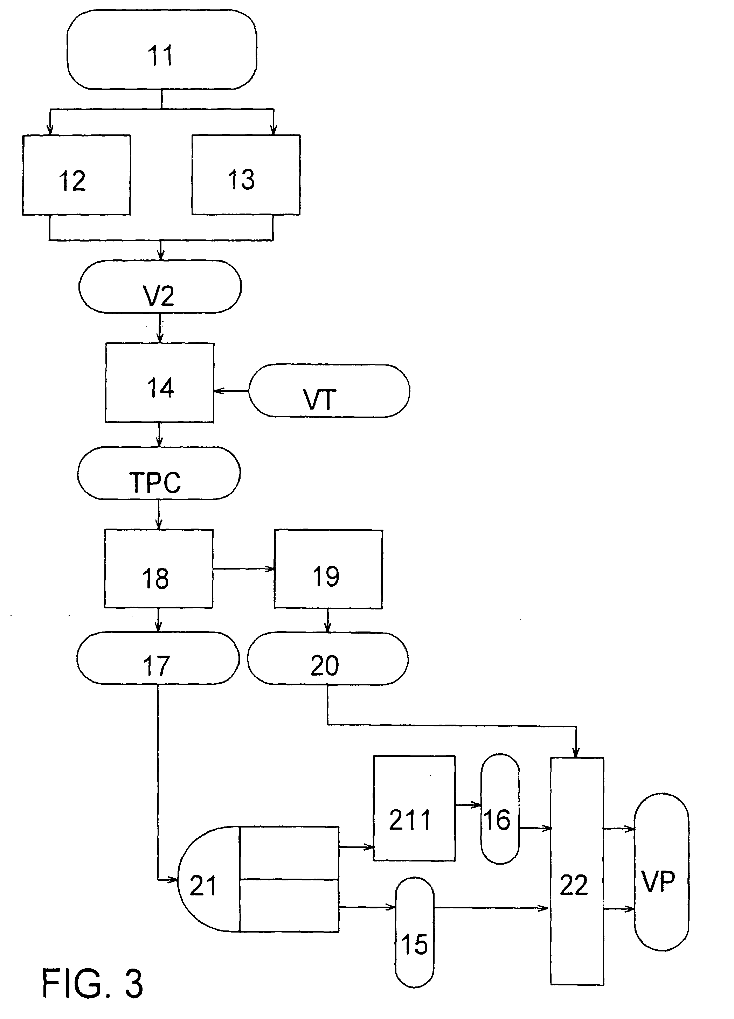

A flowchart in FIG.3 illustrates a method which departing from a first or a second type of a photodiode circuit in box 11 allows to obtain a forward biased circuit in a box 15 or a reversed biased circuit in a box 16, either one of which delivers a photovoltage VP. In a similar way as described for the flowchart in FIG.2 a signal TPC which allows an identification of either the first or the second type of photodiode circuit from box 11 is obtained through steps 12, 13 and 14. The signal TPC is stored in a memory 17 as a result of a storing step 18. In a step 19 the first output is disconnected from ground and the second output from the current source. Hence the disconnected first or second photodiode circuit in box 20 is in the same initial state as in box 11 but the signal stored in memory 17 indicates whether a first or a second photodiode is present. Subsequent to a case consideration 21, if the signal stored in memory 17 identifies a second type of photodiode circuit the second output is in a step 211 connected to a reverse biased voltage source and maintained at a constant reverse biased voltage VB. The reversed biased photodiode circuit 16 is obtained and the first and the second output of the photodiode circuit are connected in a step 22 to a first and a second electrode between which exists a photo voltage VP.

If in case consideration 21 the signal TPC stored in memory 17 does not identify the second type of photodiode circuit, a forward biased photodiode circuit 15 is obtained and the first and second output are connected in step 22 to the first and second electrode respectively.

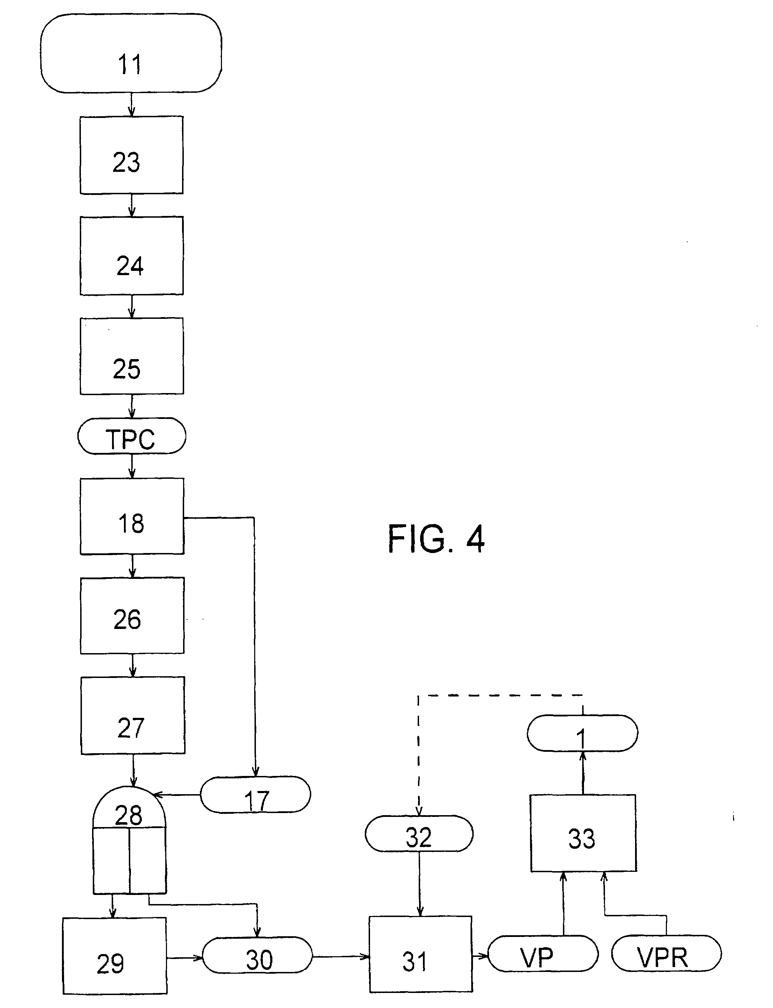

A flowchart in FIG.4 illustrates how departing from either a first or a second type of a photodiode circuit in box 11 an intensity of the light source 1 may be controlled. At first in a step 23 the photodiode circuit is disconnected from any detection circuit which might be used to obtain the photo voltage VP using the photodiode circuit. In a step 24 the first or the second photodiode circuit from box 11 is connected to a test circuit which in a step 25 allows to determine the type of the photodiode circuit connected to the test circuit and accordingly to emit the signal TPC. The step 18 stores the signal TPC in the memory 17 and the identified photocircuit is disconnected from the test circuit in a step 26. The detection circuit disconnected in step 23 is reconnected to the photodiode circuit in step 27.

A case consideration 28 looks at the content of memory 17 and if the signal stored in memory 17 identifies the second type of photodiode circuit, the detection circuit is adapted in a step 29 to be used in combination with the second type of photodiode circuit. In the opposite case, the case consideration step 28 leaves the detection circuit unmodified. It is admitted that the detection circuit may be used with the first type of photodiode circuit without being adapted. The detection circuit in box 30 is now in a state to be used with the type of photodiode circuit connected to it.

In a detection step 31 light represented by a box 32 and originating from the light source 1 falls on at least a photodiode of the connected photodiode circuit and allows to obtain a photo voltage VP. In a step 33, the photo voltage VP is compared to a reference photo voltage VPR and the intensity of the light source 1 is regulated using a result of the comparison such as to maintain the photo voltage VP at a value of the reference photo voltage VPR.

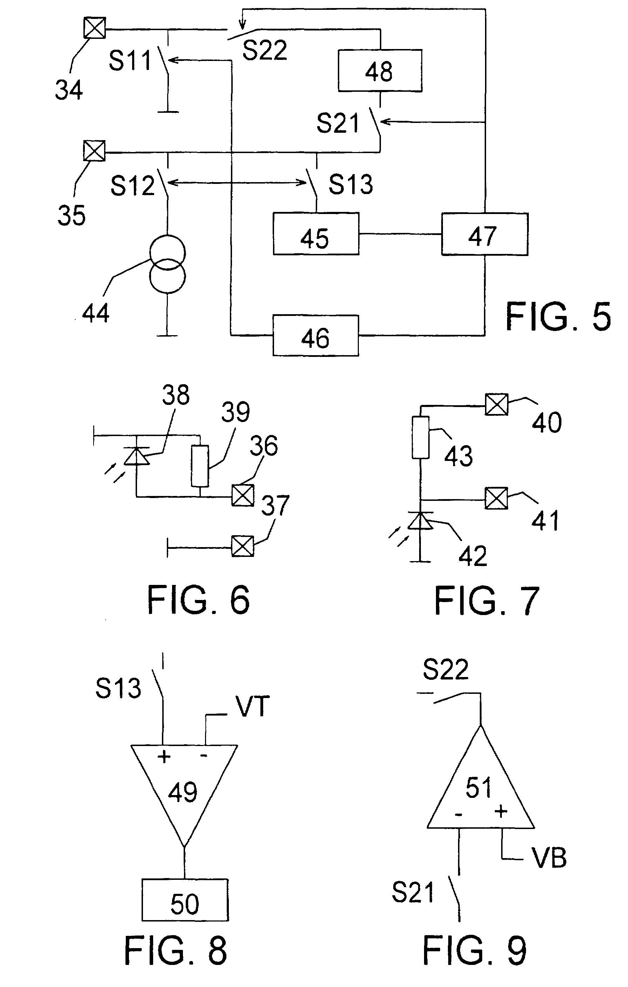

A detection circuit shown in FIG.5 may automatically adapt itself to a type of photodiode circuit (not shown in FIG.5) which is connected to the first input 34 and the second input 35, and as a result become a photodiode detection circuit using a forward or a reversed biased photodiode.

FIG.6 shows an example for a photodiode circuit, a first output 36 and a second output 37 of which may be connected to the first and the second output 34 and 35 respectively of the circuit shown in FIG.5. The photodiode circuit comprises a photodiode 38 which on one side is connected to the first output 36 and on the other side to ground. A resistor 39 is connected parallely to the photodiode 38. The second output 37 is connected to ground.

FIG.7 shows another example of a photodiode circuit which through a first output 40 and a second output 41 may be connected to the first and the second input 34 and 35 respectively of the circuit shown in FIG.5. The photodiode circuit comprises a photodiode 42 connected at one pole to ground and at an other pole to the second output 41. The first output 40 is connected to the second output 41 through a resistor 43.

Coming back to the detection circuit shown in FIG.5 the first input 34 may be connected to ground through a switch S11. The second input 35 may through a switch S12 be connected to a current source 44 which delivers a current IT having a predetermined value. The second input 35 may also be connected to voltage evaluating means 45 through a switch S13. The switches S11, S12 and S13 may simulaneously be closed or opened by first swotching means 46. An output of the voltage evaluating means 45 and an output of the first switching means 46 are connected to second switching means 47 which are used to simultaneously open or close switches S21 and S22. In a case where the switches S21 and S22 are closed a voltage at the second input 35 is fed to regulating means 48. The regulating means 48 apply a signal to the first input 34, which is a function of the signal received at an input of the regulating means 48 and is intended to regulate a value of the voltage at the second input 35.

As an example it will be described how the detection circuit from FIG.5 works when the photodiode circuit shown in FIG.6 is connected to it. At first switches S21 and S22 should be in an open state. This may for example be assured by the second switching means 47. Then the first switching means 46 simultaneously close the switches S11, S12 and S13. The current IT generated by the current source 44 flows directly to ground through the second output 37 of the photodiode circuit. As a result a voltage evaluated at an input of the voltage evaluating means 45 will reveal itself to be of a value near to zero since the current IT encounters virtually no resistance on its way to ground. The voltage evaluating means 45 having evaluated the voltage at its input, the switching means 46 simultaneously open the switches S11, S12 and S13. At the same time the first switching means 46 send a signal to the second switching means 47 indicating the open state of the switches S11, S12 and S13. The second switching means 47 receive a result of the evaluation performed by the voltage evaluating means 45 and as a result leave the switches S21 and S22 in an open state. The detection circuit is now adapted to be used with a forward biased photodiode. Light falling on the photodiode 38 generates a current between the first input 34 and ground which on turn generates a voltage at the poles of the resistor 39. The second input 35 being connected to ground through the second output 37, the voltage present between the first and the second input 34 and 35 is representative for the light intensity received by the photodiode 38.

In another example the photodiode circuit from FIG.7 is connected to the detection circuit from FIG.5. At first the switches S21 and S22 need to both be opened. This may be assured by the second switching means 47. Then the first switching means 46 simultaneously close the switches S11, S12 and S13. The current IT generated by the current source 44 may not flow to ground through the photodiode 42. Instead the current IT flows to ground through resistor 43 and through the closed switch S11. The voltage evaluating means 45 now recieve a voltage which is equal to the product between the current IT and the value of the resistor 43. After a lapse of time in which the voltage evaluating means 45 will have evaluated the voltage at his input the first switching means 46 simultaneously open switches S11, S12 and S13 and indicate this state to an input of the second switching means 47. Due to an output of the voltage evaluating means 45 the second switching means 47 simultaneously close the switches S21 and S22. The regulating means 48 receive a voltage from the second input 35, this voltage being a reverse biasing voltage. The regulating means 48 regulate the reverse biasing voltage received at its input to a predetermined reverse biasing voltage VB by emitting an appropriate signal to the first input 34. The second output 41 which is at the same voltage as the second input 35 creates at one pole of the photodiode 42 the reverse biasing voltage VB which has a positive value. Any light received by the photodiode 42 results in a current which flows to ground. At the same time a current is emitted by the regulating means 48 which flows through the resistor 43. The voltage at the poles of the resistor 43 may be measured between the first input and the second input 34 and 35 and is proportional to a light intensity received by the photodiode 42.

The second switching means 47 may comprize a logic and circuit (not shown). Two conditions normely "switches S11, S12 and S13 open" and "output of voltage evaluating means 45 equals product of current IT by value of resistor 43" are required at its input for the second switching means 47 to close S21 And S22. In FIG.8 an example for realizing the voltage evaluating means 45 is schematically represented. A comparator 49 receives at one of its inputs a predetermined reference voltage VT and at another input a signal which is dependent on whether the switch S13 is opened or closed. Referring now to the example where the photodiode circuit shown in FIG.6 is connected to the detection circuit from FIG.5, VT may be chosen such that it is of greater value then the voltage received through the closed switch S13. On the other hand VT may be also chosen such that when the photodiode circuit from FIG.7 is connected to the detection circuit it has a value smaller than a value of a voltage resulting from the current IT flowing through the resistor 43. The voltage comparator 49 may store the result of the comparison in a memory device 50 for later use.

FIG.9 shows an example of realization for the regulating means 48. A differential amplifier 51 allows to keep a voltage between its output at switch S22 and its input at switch S21 at a predetermined reverse biasing voltage VB, which is ammplied at another input.

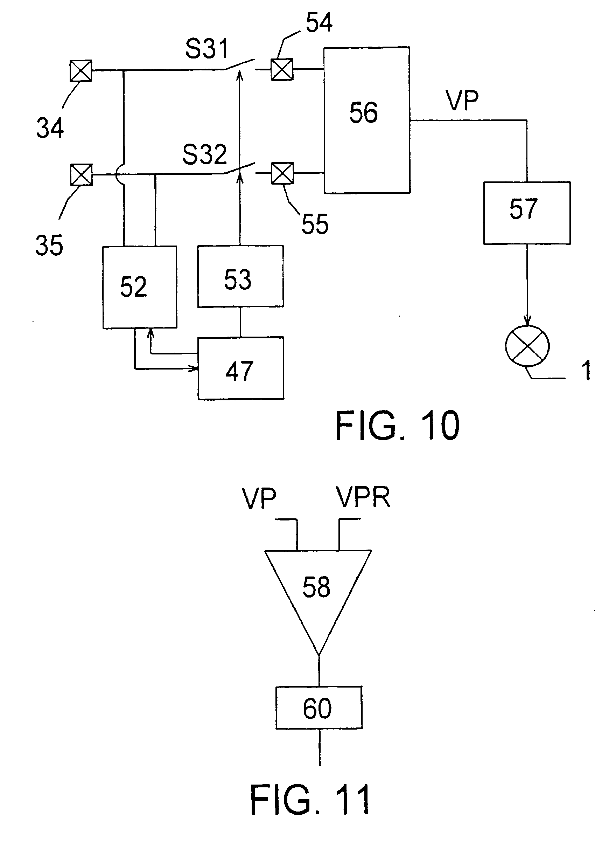

FIG.10 schematically shows a circuit which allows to monitor a light intensity measured using a photodiode circuit connected at the first and the second input 34 and 35, and to control an intensity emitted by light source 1. A detection circuit 52 and second switching means 47 automatically adapt themselves to a type of photodiode circuit which is connected to the first and second input 34 and 35. The detection circuit 52 and the second switching means 47 may be realized as described above for FIG.5. The second switching means 47 are connected to third switching means 53 which allow to simultaneously open or close switches S31 and S32.

A voltage between a first and a second electrode 54 and 55 is evaluated by further evaluating means 56 which at an output deliver a photo voltage VP in case the switches S31 and S32 are closed. A value of the photo voltage VP is proportional to a light intensity received by a photodiode of the connected photodiode circuit. The light intensity received provides from the light source 1. The photovoltage is fed to an input of power regulating means 57 an output of which is connected to the light source 1. The power regulating means 57 regulate the intensity of the light source 1 such that the photo voltage VP be kept to a constant value.

FIG.11 schematically shows an example of how to realize the power regulating means 57. A comparator 58 compares the photo voltage VP at an input with a predetermined reference photo voltage VPR at another input. A result of this comparison may be used to regulate with a regulator 60 the power fed to the light source 1 in a manner known from a person skilled in the art.

The described examples of a detection circuit and / or of a light intensity monitoring and controlling circuit may be used in an optical disc player and / or recorder (not shown). Typically a semi-conductor laser diode is used as the light source 1. Light emitted by the semi-conductor laser diode is directed to an optical disc to scan information stored on the disc. Light reflected and or reflected by the optical disc is received by the photodiode of the photodiode circuit.

A detection circuit according to the present invention may be realized in an integrated circuit. The same is true for a light intensity monitor and controlling circuit. The first and the second input 34 and 35 are pins of the integrated circuit to which the first and the second outputs of the photodiode circuit may e.g. be soldered. The first switching means 46 may be initiated to simultaneously close the switches S11, S12 and S13 by feeding a test enable signal to them. After a lapse of time has passed in which a possible current IT has stabilised a measure enable signal is given to the voltage evaluating means 45 instructing it to evaluate the voltage at its input and store the result of the evaluation in a memory device. While the test enable signal is applied the photodiode of the photodiode circuit should not receive any light, i.e. the light source should be switched off. Once no more test enable signal is applied the first switching means 46 enable the second switching means 47 to close or not to close the switches S21 and S22. At this point the light source 1 may be turned on and light received by the photodiode of the photodiode circuit detected.

Other ways of realizing the inventions and variations of the described example may well be found by a person skilled in the art while remaining in the scope of the claimed invention.

## Claims

1. Method for automatically identifying a first or a second type of photodiode circuit (11) which each have a first and a second output, comprising the steps of
- connecting said first output to ground (12),
- connecting to said second output a current source of a predetermined current value (13),
- comparing (14) a voltage (V2) at said second output with a predetermined reference voltage (VT),
- emitting a signal (TPC) indicating a result of said comparing which allows an identification of either said first or said second type of photodiode circuit.

2. Method for automatically obtaining a forward or a reversed biased photodiode device delivering between a first and or second electrode a photovoltage of a predetermined polarity, depending on either one of a first or a second type of photodiode circuit (11) to be used which each have a first and a second output comprising the steps of:
- using the method according to claim 1 for automatically identifying the first or the second type of photodiode circuit (11)
- storing (18) the signal (TPC) which allows an identification of at least said second type of photodiode circuit,
- connecting said first and said second output to said first and second electrode respectively,
- maintaining (211) said second output at a constant reverse biasing voltage (VB) if said stored signal identifies said second type of photodiode circuit by comparing a biasing voltage value at said second output with a reference biasing voltage value and accordingly to a result of this comparison applying a variable current to said first output.

3. Method for controlling an intensity of a light source comprising the steps of:
- connecting either one of a first or a second type of photodiode circuit (11) to a detection circuit,
- adapting (29) said detection circuit for said first or said second type of photodiode circuit connected to it,
- receiving (31) on at least a photodiode of said first or said second photodiode circuit light (32) emitted by said light source (1),
- obtaining at an output of said detection circuit (30) a photovoltage (VP) of a predetermined polarity,
- regulating an intensity of said light source (1) such to maintain said photovoltage (VP) at a reference photovoltage value (VPR),
said method being **characterized in that** it further comprises the steps of:
- disconnecting (23) said detection circuit from said first or said second type of photodiode circuit,
- connecting (24) to said first or said second type of photodiode circuit a test circuit, the test circuit performing the method according to claim 1 for automatically identifying the first or the second type of photodiode circuit (11),
- determining (25) at least whether said second type of photodiode circuit is connected to said test circuit,
- storing (18) a positive result if said determining reveals said second type of photodiode circuit,
- disconnecting (26) said test circuit,
- performing said adapting (29) for said second type of photodiode circuit if said stored result is positive (28), or else for said first type of photodiode circuit.

4. Automatically adapting forward or reversed biased photodiode detection circuit comprising a first (34) and a second (35) input for connecting a photodiode circuit (36, 37, 38, 39; 40, 41, 42, 43), said first input being connected to ground over a first switch (S11), said second input being connected over a second switch (S12) to a current source (44) and over a third switch (S13) to voltage evaluation means (45), first switching means (46) for simultaneously opening or closing said first, second and third switches, regulating means (48) having an input connected over a fourth switch (S21) to said second input and an output connected over a fifth switch (S22) to said first input to regulate a biasing voltage at said second input to a predetermined reverse biasing voltage (VB), second switching means (47) for simultaneously opening or closing said fourth and fifth switches and being connected to an output of said voltage evaluating means and to said first switching means.

5. Photodiode detection circuit according to claim 4, **characterized in that** said voltage evaluating means comprise (45) a voltage source which generates a predetermined reference voltage (VT), a voltage comparator (49) one input of which is connected to said voltage source, another input of which is connected to said third switch (S13), a memory device (50) to store a result of a comparison delivered at an output of said voltage comparator.

6. Photodiode detection circuit according to anyone of claims 4 or 5, **characterized in that** said regulating means (48) comprise a further voltage source which generates said predetermined reverse biasing voltage (VB), an amplifier (51) an input of which is connected to said further voltage source, another input of which is connected to said fourth switch (S21), an output of which is connected to said fifth switch (S22).

7. Photodiode detection circuit according to anyone of claims 4 to 6 **characterized in that** said second switching means (47) comprise a logic AND circuit.

8. Light intensity monitoring and controlling circuit comprising an automatically adapting forward or reversed biased photodiode detection circuit according to anyone of claims 4 to 7, further voltage evaluating means (56) to determine a photovoltage value (VP) of a voltage between said first (34) and said second (35) input, said further voltage evaluating means having a first and a second evaluating input connected to said first and said second input through a sixth (S31) and a seventh (S32) switch respectively, said photovoltage value being emitted at an evaluating output, third switching means (53) which allow to simultaneously open or close said sixth (S31) and said seventh (S32) switch and an input of which is connected to said second switching means (47), power regulating means (57) which allow to regulate an intensity of a light source (1) as a function of said photovoltage value, said power regulating means being connected to said evaluating output.

9. Light intensity monitoring and controlling circuit according to claim 8, **characterized in that** said power regulating means (57) comprise a reference photovoltage source which generates a predetermined reference voltage (VPR), photovoltage comparing means (48) to compare said predetermined reference photovoltage with said photovoltage (VP), a result of the photovoltage comparing being used to regulate said intensity.

10. Optical disk player and/or recorder comprising a light intensity monitoring and controlling circuit according to anyone of claims 8 or 9 in which said light source is a semi-conductor laser diode, an optical disk is read and/or recorded using light emitted by said laser diode and at least one photodiode comprised in said photodiode circuit receives light reflected or transmitted by said optical disk during a reading and/or recording on the same.

## Patentansprüche

1. Methode zur automatischen Identifizierung eines ersten oder eines zweiten Typs eines Fotodiodenschaltkreises (11), von denen jeder einen ersten und zweiten Ausgang besitzt, umfassend die folgenden Schritte
- Anschluss des besagten ersten Ausgangs an Masse (12),
- Anschluss einer Stromquelle eines vorher festgelegten Stromwertes (13) an den besagten zweiten Ausgang,
- Vergleich (14) einer Spannung (V2) an dem besagten zweiten Ausgang mit einer vorher festgelegten Referenzspannung (VT),
- Emittieren eines Signals (TPC), das ein Ergebnis des besagten Vergleichs anzeigt und eine Identifizierung des besagten ersten Typs oder des besagten zweiten Typs eines Fotodiodenschaltkreises erlaubt.

2. Methode für den automatischen Erhalt einer in Durchlassrichtung oder einer in Sperrrichtung vorgespannten Fotodiodenvorrichtung, die zwischen einer ersten und einer zweiten Elektrode eine Fotospannung einer vorher festgelegten Polarität liefert, je nachdem, ob ein erster oder ein zweiter Typ eines Fotodiodenschaltkreises (11) benutzt werden soll, die jeweils einen ersten und einen zweiten Ausgang besitzen, umfassend die folgenden Schritte:
- Benutzung der Methode gemäß Anspruch 1 für die automatische Identifizierung des ersten oder des zweiten Typs einen Fotodiodenschaltkreises (11),
- Speichern (18) des Signals (TPC), das eine Identifizierung von mindestens dem zweiten Typ des Fotodiodenschaltkreises erlaubt,
- Anschluss des besagten ersten und des besagten zweiten Ausgangs an die besagte erste bzw. die besagte zweite Elektrode,
- Halten (211) des besagten zweiten Ausgangs auf einer konstanten Vorspannung in Sperrrichtung (VB), wenn besagtes gespeichertes Signal den besagten zweiten Typ des Fotodiodenschaltkreises identifiziert, indem ein Vorspannungswert am besagten zweiten Ausgang mit einem Vorspannungsreferenzwert verglichen wird und in Einklang mit einem Ergebnis dieses Vergleichs ein variabler Strom an den besagten ersten Ausgang angelegt wird.

3. Methode zur Steuerung einer Stärke einer Lichtquelle, umfassend die folgenden Schritte:
- Anschluss eines ersten oder eines zweiten Typs eines Fotodiodenschaltkreises (11) an einen Erkennungsschaltkreis,
- Anpassung (29) des besagten Erkennungsschaltkreises an den besagten ersten oder an den besagten zweiten an ihn angeschlossen Typ des Fotodiodenschaltkreises,
- Empfang (31) von von der besagten Lichtquelle (1) abgegebenem Licht (32) mit mindestens einer Fotodiode des besagten ersten oder des besagten zweiten Typs des Fotodiodenschaltkreises,
- Erhalt einer Fotospannung (VP) einer vorher festgelegten Polarität an einem Ausgang des besagten Erkennungsschaltkreises (30),
- Regeln einer Stärke der besagten Lichtquelle (1), um die besagte Fotospannung (VP) auf einem Fotospannungs-Referenzwert (VPR) zu halten,
wobei die besagte Methode **dadurch gekennzeichnet ist, dass** sie außerdem folgende Schritte umfasst:
- Trennen (23) des besagten Erkennungsschaltkreises von dem besagten ersten Typ oder dem besagten zweiten Typ des Fotodiodenschaltkreises,
- Anschluss (24) eines Prüfschaltkreises an den besagten ersten Typ oder dem besagten zweiten Typ des Fotodiodenschaltkreises, wobei der Prüfschaltkreis die Methode in Einklang mit Anspruch 1 zur automatischen Identifizierung des ersten oder zweiten Typs des Fotodiodenschaltkreises (11) durchführt,
- mindestens Feststellung (25), ob der besagte zweite Typ des Fotodiodenschaltkreises an den besagten Prüfschaltkreis angeschlossen ist,
- Speichern (18) eines positiven Ergebnisses, wenn besagte Feststellung den besagten zweiten Typ des Fotodiodenschaltkreises ergibt,
- Trennen (26) des besagten Prüfschaltkreises,
- Durchführung der besagten Anpassung (29) für den besagten zweiten Typ des Fotodiodenschaltkreises, wenn das besagte gespeicherte Ergebnis positiv ist (28), oder anderenfalls für den besagten ersten Typ des Fotodiodenschaltkreises.

4. Automatisch anpassender Fotodioden-Erkennungsschaltkreis für eine in Durchlassrichtung oder in Sperrrichtung vorgespannte Fotodiode, umfassend einen ersten (34) und einen zweiten (35) Eingang für den Anschluss eines Fotodiodenschaltkreises (36, 37, 38, 39, 40, 41, 42, 43), wobei der besagte erste Eingang über einen ersten Schalter (S11) an Masse angeschlossen ist, der besagte zweite Eingang über einen zweiten Schalter (S12) an eine Stromquelle (44) und über einen dritten Schalter (S13) an ein Spannungsauswertemittel (45) angeschlossen ist, ein erstes Schaltmittel (46) für das simultane Öffnen oder Schließen der besagten ersten, zweiten und dritten Schalter, ein Regelungsmittel (48), von dem ein Eingang über einen vierten Schalter (S21) an den besagten zweiten Eingang angeschlossen ist und ein Ausgang über einen fünften Schalter (S22) an den besagten ersten Eingang angeschlossen ist, um eine Vorspannung am besagten zweiten Eingang auf eine vorher festgelegte Vorspannung in Sperrrichtung (VB) zu regeln, ein zweites Schaltmittel (47) für das simultane Öffnen oder Schließen des besagten vierten und fünften Schalters, das an einen Ausgang des besagten Spannungsauswertemittels und an das besagte erste Schaltmittel angeschlossen ist.

5. Fotodioden-Erkennungsschaltkreis gemäß Anspruch 4, **dadurch gekennzeichnet, dass** das besagte Spannungsauswertemittel (45) eine Spannungsquelle, die eine vorher festgelegte Referenzspannung (VT) generiert, einen Spannungskomparator (49), von dem ein Eingang an die besagte Spannungsquelle angeschlossen ist und von dem ein anderer Eingang an den besagten dritten Schalter (S13) angeschlossen ist, eine Speichervorrichtung (50) zur Speicherung eines Ergebnisses eines Vergleichs, geliefert an einen Ausgang des besagten Spannungskomparators, umfasst.

6. Fotodioden-Erkennungsschaltkreis gemäß einem der Ansprüche 4 oder 5, **dadurch gekennzeichnet, dass** das besagte Regelungsmittel (48) eine weitere Spannungsquelle, die die besagte vorher festgelegte Vorspannung in Sperrrichtung (VB) generiert, einen Verstärker (51), von dem ein Eingang an die besagte weitere Spannungsquelle angeschlossen ist, von.dem ein anderer Eingang an den besagten vierten Schalter (S21) angeschlossen ist, und von dem ein Ausgang an den besagten fünften Schalter (S22) angeschlossen ist, umfasst.

7. Fotodioden-Erkennungsschaltkreis gemäß einem der Ansprüche 4 bis 6, **dadurch gekennzeichnet, dass** das besagte zweite Schaltmittel (47) einen logischen UND-Schaltkreis umfasst.

8. Lichtstärke-Überwachungs- und Steuerschaltkreis, umfassend einen sich automatisch anpassenden Fotodioden-Erkennungsschaltkreis gemäß einem der Ansprüche 4 bis 7 für eine in Durchlassrichtung oder in Sperrrichtung vorgespannte Fotodiode, ein weiteres Spannungsauswertemittel (56) zur Bestimmung eines Fotospannungswerts (VP) einer Spannung zwischen dem besagten ersten (34) und dem besagten zweiten (35) Eingang, wobei das besagte weitere Spannungsauswertemittel einen ersten und einen zweiten Auswerteeingang besitzt, der über einen sechsten (S31) bzw. über einen siebten (S32) Schalter an den besagten ersten und den besagten zweiten Eingang angeschlossen ist, und der besagte Fotospannungswert an einem Auswerteausgang abgegeben wird, ein drittes Schaltmittel (53), das das simultane Öffnen oder Schließen des besagten sechsten Schalters (S31) und des besagten siebten Schalters (S32) erlaubt, und von dem ein Eingang an das besagte zweite Schaltmittel (47) angeschlossen ist, ein Leistungsregelungsmittel (57), das die Regelung einer Stärke einer Lichtquelle (1) als eine Funktion des besagten Fotospannungswerts erlaubt, wobei besagtes Leistungsregelungsmittel an den besagten Auswerteausgang angeschlossen ist.

9. Lichtstärke-Überwachungs- und Steuerschaltkreis gemäß Anspruch 8, **dadurch gekennzeichnet, dass** besagtes Leistungsregelungsmittel (57) eine Referenz-Fotospannungsquelle umfasst, die eine vorher festgelegte Referenzspannung (VPR) generiert, ein Fotospannungsvergleichsmittel (48), um die besagte, vorher festgelegte Referenz-Fotospannung mit der besagten Fotospannung (VP) zu vergleichen, wobei ein Ergebnis des Fotospannungsvergleichs zur Regelung der besagten Stärke benutzt wird.

10. Abspielgerät und/oder Recorder für optische Platten, der einen Lichtstärke-Überwachungs- und Steuerschaltkreis gemäß Anspruch 8 oder 9 aufweist, in dem die besagte Lichtquelle eine Halbleiter-Laserdiode ist, eine optische Platte unter Verwendung von von der besagten Laserdiode abgegebenem Licht gelesen und/oder beschrieben wird, und in dem mindestens eine im besagten Fotodiodenschaltkreis enthaltene Fotodiode Licht empfängt, das während des Lesens und/oder Beschreibens der optischen Platte von der optischen Platte reflektiert oder transmittiert wird.

## Revendications

1. Procédé permettant d'identifier automatiquement un premier ou un second type de circuit de photodiode (11), lesquels ont chacun une première et une seconde sortie, et comprenant les étapes :
- de connexion de ladite première sortie à la terre (12),
- de connexion à ladite seconde sortie d'une source de courant d'une valeur actuelle prédéfinie (13),
- de comparaison (14) d'une tension (V2) à ladite seconde sortie à une tension de référence (VT) prédéfinie,
- d'émission d'un signal (TPC) indiquant un résultat de ladite comparaison, qui rend possible une identification de l'un ou l'autre dudit premier ou dudit second types de circuit de photodiode.

2. Procédé permettant d'obtenir automatiquement un dispositif de photodiode en polarisation directe ou polarisation inversée délivrant, entre une première et/ou une seconde électrode, un photovoltage d'une polarité prédéfinie, dépendant de l'un ou l'autre premier ou second type de circuit de photodiode (11) utilisés, lesquels ont chacun une première et une seconde sortie, et comprenant les étapes :
- de reprise du procédé selon la revendication 1 permettant d'identifier automatiquement le premier ou le second type de circuit de photodiode (11),
- de stockage (18) du signal (TPC) qui rend possible une identification au moins dudit second type de circuit de photodiode,
- de connexion de ladite première et de ladite seconde sorties aux dites première et seconde électrodes respectivement,
- de maintien (211) de ladite seconde sortie à une tension de polarisation inversée (VB) constante si ledit signal stocké identifie ledit second type de circuit de photodiode en comparant une valeur de tension de polarisation à ladite seconde sortie à une valeur de tension de polarisation de référence et, suite à un résultat de cette comparaison, en appliquant un courant variable à ladite première sortie.

3. Procédé permettant de contrôler l'intensité d'une source lumineuse, comprenant les étapes :
- de connexion de l'un ou l'autre premier ou second type de circuit de photodiode (11) à un circuit de détection,
- de configuration (29) dudit circuit de détection pour ledit premier ou ledit second type de circuit de photodiode auquel il est connecté,
- de réception (31), sur au moins une photodiode dudit premier ou dudit second circuit de photodiode, de la lumière (32) émise par ladite source lumineuse (1),
- d'obtention à une sortie dudit circuit de détection (30) d'un photovoltage (VP) d'une polarité prédéfinie,
- de régulation d'une intensité de ladite source lumineuse (1) de façon à obtenir ledit photovoltage (VP) à une valeur de photovoltage de référence (VPR),
ledit procédé étant **caractérisé en ce qu'**il comprend en plus les étapes :
- de déconnexion (23) dudit circuit de détection audit premier
ou audit second type de circuit de photodiode,
- de connexion (24) audit premier ou audit second type de circuit de photodiode d'un montage d'essai, le montage d'essai exécutant le procédé selon la revendication 1 permettant d'identifier automatiquement le premier ou le second type de circuit de photodiode (11),
- de vérification (25) au moins que ledit second type de circuit de photodiode est connecté audit montage d'essai,
- de stockage (18) d'un résultat positif si ladite vérification révèle ledit second type de circuit de photodiode,
- de déconnexion (26) dudit montage d'essai,
- d'exécution de ladite configuration (29) pour ledit second type de circuit de photodiode si ledit résultat stocké est positif (28), ou sinon pour ledit premier type de circuit de photodiode.

4. Circuit de détection de photodiode pour la configuration automatique en polarisation directe ou polarisation inversée, comprenant une première (34) et une seconde (35) entrées permettant de connecter un circuit de photodiode (36, 37, 38, 39, 40, 41, 42, 43), ladite première entrée étant connectée à la terre par l'intermédiaire d'un premier commutateur (S11), ladite seconde entrée étant connectée par l'intermédiaire d'un second commutateur (S12) à une source de courant (44) et par l'intermédiaire d'un troisième commutateur (S13) au moyen d'évaluation de la tension (45), un premier moyen de commutation (46) permettant d'ouvrir ou de fermer simultanément lesdits premier, second et troisième commutateurs, un moyen régulateur (48) ayant une entrée connectée par l'intermédiaire d'un quatrième commutateur (S21) à ladite seconde entrée et une sortie connectée par l'intermédiaire d'un cinquième commutateur (S22) à ladite première entrée pour régler une tension de polarisation à ladite seconde entrée à une tension de polarisation inversée (VB) prédéfinie, un second moyen de commutation (47) permettant d'ouvrir ou de fermer simultanément lesdits quatrième et cinquième commutateurs et étant connecté à une sortie dudit moyen d'évaluation de la tension et audit premier moyen de commutation.

5. Circuit de détection de photodiode selon la revendication 4, **caractérisé en ce que** ledit moyen d'évaluation de la tension (45) comprend une source de tension qui génère une tension de référence (VT) prédéfinie, un comparateur de tension (49) dont une entrée est connectée à ladite source de tension et dont une autre entrée est connectée audit troisième commutateur (S13), un dispositif de mémoire (50) pour stocker un résultat d'une comparaison délivré à une sortie dudit comparateur de tension.

6. Circuit de détection de photodiode selon les revendications 4 et 5, **caractérisé en ce que** ledit moyen régulateur (48) comprend une nouvelle source de tension qui génère ladite tension de polarisation inversée (VB) prédéfinie, un amplificateur (51) dont une entrée est connectée à ladite nouvelle source de tension, une autre entrée est connectée audit quatrième commutateur (S21) et dont une sortie est connectée audit cinquième commutateur (S22).

7. Circuit de détection de photodiode selon les revendications 4 à 6, **caractérisé en ce que** ledit second moyen de commutation (47) comprend une logique ET un circuit.

8. Circuit directeur et contrôleur d'intensité lumineuse, comprenant un circuit de détection de photodiode pour la configuration automatique en polarisation directe ou polarisation inversée selon les revendications 4 à 7, un nouveau moyen d'évaluation de la tension (56) pour déterminer une valeur de photovoltage (VP) d'une tension entre ladite première (34) et ladite seconde (35) entrées, ledit nouveau moyen d'évaluation de la tension ayant une première et une seconde entrées d'évaluation, connectées à ladite première et à ladite seconde entrées par l'intermédiaire d'un sixième (S31) et d'un septième (S32) commutateurs respectivement, ladite valeur de photovoltage étant émise à une sortie d'évaluation, un troisième moyen de commutation (53) qui permet d'ouvrir ou de fermer simultanément ledit sixième (S31) et ledit septième (S32) commutateurs et dont une entrée est connectée audit second moyen de commutation (47), un moyen régulateur de courant (57) qui permet de réguler une intensité d'une source lumineuse (1) comme une fonction de ladite valeur de photovoltage, ledit moyen régulateur de courant étant connecté à ladite sortie d'évaluation.

9. Circuit directeur et contrôleur d'intensité lumineuse selon la revendication 8, **caractérisé en ce que** ledit moyen régulateur de courant (57) comprend une source de photovoltage de référence qui génère une tension de référence (VPR) prédéfinie, un moyen de comparaison du photovoltage (48) pour comparer ledit photovoltage de référence prédéfini audit photovoltage (VP), un résultat de la comparaison du photovoltage étant utilisé pour réguler ladite intensité.

10. Lecteur et/ou enregistreur de disques optiques, comprenant un circuit directeur et contrôleur d'intensité lumineuse selon les revendications 8 ou 9, dans lequel ladite source lumineuse est une diode laser, un disque optique est lu et/ou enregistré en utilisant la lumière émise par ladite diode laser et au moins une photodiode comprise dans ledit circuit de photodiode reçoit la lumière réfléchie ou transmise par ledit disque optique lors d'une lecture et/ou d'un enregistrement sur le même disque.
